# EUROPEAN PATENT APPLICATION

(11) **EP 4 650 802 A1**
(43) Date of publication of application: **19.11.2025**
(21) Application number: 24907632.4
(22) Date of filing: 19.06.2024
(51) Int. Cl.: G01R 31/389, G01R 31/382, G01R 31/396, B60L 58/12

(54) **APPARATUS AND METHOD OF ESTIMATING THE BATTERY INTERNAL RESISTANCE**

(30) Priority: 18.12.2023 KR 20230184424
(71) Applicant: LG Energy Solution, Ltd., Seoul 07335 (KR)
(72) Inventor: CHAE, Minyoung, Daejeon 34122 (KR)
(74) Representative: Plasseraud IP
(86) International application number: PCT/KR2024/008470
(87) International publication number: WO 2025/135342

(57) **Abstract**

The present invention relates to an apparatus and method of estimating the battery internal resistance, and a battery internal resistance estimating apparatus according to an exemplary embodiment of the present invention includes a storage unit that stores a plurality of battery charging information items which is obtained during charging of a battery with a plurality of constant currents, and a control unit that reads multiple battery charging information items having an initial SOC identical to a target initial SOC from among the plurality of battery charging information items, determines whether there is any battery charging information item corresponding to a constant current identical to a target constant current among the multiple read battery charging information items, and estimates the internal resistance of the battery according to the target initial SOC and the charging with the target constant current, using two battery charging information items corresponding to two constant currents close to the target constant current, when it is determined that there is no battery charging information item according to a constant current identical to the target constant current.

## Description

### [Technical Field]

### CROSS-REFERENCE TO RELATED APPLICATION

This application claims priority to and the benefit of Korean Patent Application No. 10-2023-0184424 filed in the Korean Intellectual Property Office on December 18, 2023, the entire contents of which are incorporated herein by reference.

The present invention relates to a method of estimating battery internal resistance and a battery internal resistance estimating apparatus for performing the method.

### [Background Art]

Batteries, which are mounted in high-powered products such as electric vehicles or hybrid vehicles, should supply high voltage to loads, and thus, include a number of cells connected in series or in parallel. As vehicles are driven, battery deterioration and battery degradation occur, resulting in an increase in the battery internal resistance.

The internal resistance of a battery is used as an indicator important in estimating the battery state such as the state of charge (SOC) of the battery or the state of health (SOH) of the battery. Therefore, it is important to calculate the internal resistance of batteries.

### [Disclosure]

### [Technical Problem]

The present invention attempts to provide a method of estimating battery internal resistance in an arbitrary battery charging environment using battery charging information when charging is performed by constant current (CC), and a battery internal resistance estimating apparatus for performing the method.

### [Technical Solution]

A battery internal resistance estimating apparatus according to an exemplary embodiment of the present invention includes a storage unit that stores a plurality of battery charging information items which is obtained during charging of a battery with a plurality of constant currents, and a control unit that reads multiple battery charging information items having an initial SOC identical to a target initial SOC from among the plurality of battery charging information items, determines whether there is any battery charging information item corresponding to a constant current identical to a target constant current among the multiple read battery charging information items, and estimates the internal resistance of the battery according to the target initial SOC and the charging with the target constant current, using two battery charging information items corresponding to two constant currents close to the target constant current, when it is determined that there is no battery charging information item corresponding to a constant current identical to the target constant current.

The control unit may estimate the internal resistance of the battery according to the target initial SOC and the charging with the target constant current, using a first battery charging information item corresponding to a first constant current larger than and closest to the target constant current among the multiple read battery charging information items and a second battery charging information item corresponding to a second constant current smaller than and closest to the target constant current among the multiple read battery charging information items.

The control unit may determine first internal resistance of the battery, using the first battery charging information item, determine second internal resistance of the battery, using the second battery charging information item, and estimate the internal resistance of the battery according to the target initial SOC and the charging with the target constant current, on the basis of the first internal resistance and the second internal resistance.

The control unit may estimate the internal resistance of the battery according to the target initial SOC and the charging with the target constant current by interpolating between the first internal resistance and the second internal resistance.

The control unit may search the multiple read battery charging information items for first preliminary battery charging information items having a constant current larger than and closest to the target constant current, and when there is a plurality of first preliminary battery charging information items, the control unit may determine a preliminary battery charging information item including a temperature at the start of battery charging closest to a temperature at the start of target battery charging among the plurality of first preliminary battery charging information items, as the first battery charging information item.

A battery internal resistance estimating method according to an exemplary embodiment of the present invention includes a step of storing a plurality of battery charging information items which is obtained during charging of a battery with a plurality of constant currents, a step of reading multiple battery charging information items having an initial SOC identical to a target initial SOC from among the plurality of battery charging information items, a step of determining whether there is any battery charging information item corresponding to a constant current identical to a target constant current among the multiple read battery charging information items, and a step of estimating the internal resistance of the battery according to the target initial SOC and charging with the target constant current, using two battery charging information items corresponding to two constant currents close to the target constant current, when it is determined that there is no battery charging information item corresponding to a constant current identical to the target constant current.

The step of estimating the internal resistance of the battery according to the target initial SOC and the charging with the target constant current may include a step of determining a first battery charging information item corresponding to a first constant current larger than and closest to the target constant current from among the multiple read battery charging information items, a step of determining a second battery charging information item corresponding to a second constant current smaller than and closest to the target constant current from among the multiple read battery charging information items, and a step of estimating the internal resistance of the battery according to the target initial SOC and charging with the target constant current, using the first battery charging information item and the second battery charging information item.

The step of estimating the internal resistance of the battery according to the target initial SOC and charging with the target constant current, using the first battery charging information item and the second battery charging information item may include a step of determining first internal resistance of the battery, using the first battery charging information item, a step of determining second internal resistance of the battery, using the second battery charging information item, and a step of estimating the internal resistance of the battery according to the target initial SOC and the charging with the target constant current, on the basis of the first internal resistance and the second internal resistance.

The step of estimating the internal resistance of the battery according to the target initial SOC and the charging with the target constant current, on the basis of the first internal resistance and the second internal resistance may include a step of estimating the internal resistance of the battery according to the target initial SOC and the charging with the target constant current by interpolating between the first internal resistance and the second internal resistance.

The step of determining the first battery charging information item corresponding to the first constant current may include a step of searching the multiple read battery charging information times for first preliminary battery charging information items including a constant current larger than and closest to the target constant current, and when the number of first preliminary battery charging information items is two or more, the step of determining the first battery charging information item may include a step of determining a first preliminary battery charging information item including a temperature at the start of battery charging closest to a temperature at the start of target battery charging, as the first battery charging information item, from among the plurality of first preliminary battery charging information items.

### [Advantageous Effects]

A method of estimating battery internal resistance in an arbitrary battery charging environment using battery charging information when charging is performed by constant current (CC), and a battery internal resistance estimating apparatus for performing the method are provided.

### [Description of the Drawings]

FIG. 1 is a block diagram illustrating an example to which a battery internal resistance estimating apparatus according to an exemplary embodiment is applied.
FIG. 2 is a block diagram illustrating the internal configuration of the vehicle of FIG. 1.
FIG. 3 is a block diagram illustrating the configuration of the battery system of FIG. 2 in detail.
FIG. 4 is a block diagram illustrating the configuration of the battery internal resistance estimating apparatus of FIG. 1 in detail.
FIG. 5 is a flow chart illustrating a method of estimating battery internal resistance depending on a target initial SOC and target constant-current charging according to an exemplary embodiment.
FIG. 6 is a flow chart illustrating a method of determining a first battery charging information item and a second battery charging information item according to the exemplary embodiment.
FIG. 7 is a graph illustrating the change in battery voltage over battery charging time.

### [Mode for Invention]

The exemplary embodiments described in this specification and the configurations shown in the drawings are just the most preferred exemplary embodiments of the present invention, and there may be various equivalents and modifications that replace them at the time of filing the application.

When describing exemplary embodiments disclosed in this specification, detailed descriptions of publicly known technologies will be omitted if it is determined that specific description thereof may obscure the gist of the exemplary embodiments disclosed in this specification. Further, the accompanying drawings are provided for helping to easily understand exemplary embodiments disclosed in the present specification, and the technical spirit disclosed in the present specification is not limited by the accompanying drawings, and it will be appreciated that the present invention includes all of the modifications, equivalent matters, and substitutes included in the spirit and the technical scope of the present invention.

Terms including an ordinal number, such as first and second, are used for describing various constituent elements, but the constituent elements are not limited by the terms. The terms are used only to discriminate one constituent element from another constituent element.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

Hereinafter, exemplary embodiments disclosed in this specification will be described in detail with reference to the accompanying drawings.

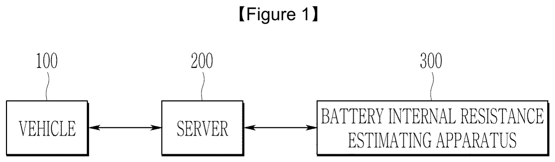

FIG. 1 is a block diagram illustrating an example to which a battery internal resistance estimating apparatus according to an exemplary embodiment is applied.

A battery internal resistance estimating apparatus 300 may estimate the internal resistance of a battery which is mounted in a vehicle 100 (hereinafter, referred to as the battery internal resistance).

The battery internal resistance estimating apparatus 300 may obtain information necessary for battery internal resistance estimation from the vehicle 100 through a server 200. However, the present invention is not limited thereto, and the battery internal resistance estimating apparatus 300 may obtain the corresponding information directly from the vehicle 100.

The vehicle 100 according to the exemplary embodiment may be an electric vehicle or a hybrid vehicle in which a battery system 110 is mounted. However, the present invention is not limited thereto, and instead of the vehicle 100, various kinds of higher-level systems may include the battery system 110.

The vehicle 100 and the server 200 may be connected to each other through a network. The network refers to a connection structure in which individual nodes such as terminals and servers such as the server 200 can exchange information with one another, and includes local area networks (LANs), wide area networks (WANs), the Internet (the world wide web (WWW)), wired and wireless data communication networks, telephone networks, wired and wireless television communication networks, etc. Examples of wireless data communication networks include 4G, 5G, long term evolution (LTE), Wi-Fi, Bluetooth communication, infrared communication, ultrasonic communication, visible light communication (VLC), LiFi, etc.

The server 200 may receive a variety of data, and process and store the received data, and transmit the processed data. More specifically, the server 200 may store battery charging information received from the vehicle 100, and transmit them to the battery internal resistance estimating apparatus 300, and may transmit internal resistance, estimated by the battery internal resistance estimating apparatus 300, to the vehicle 100.

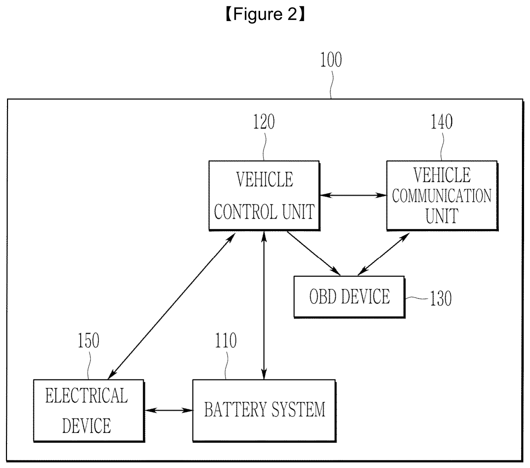

FIG. 2 is a block diagram illustrating the internal configuration of the vehicle of FIG. 1.

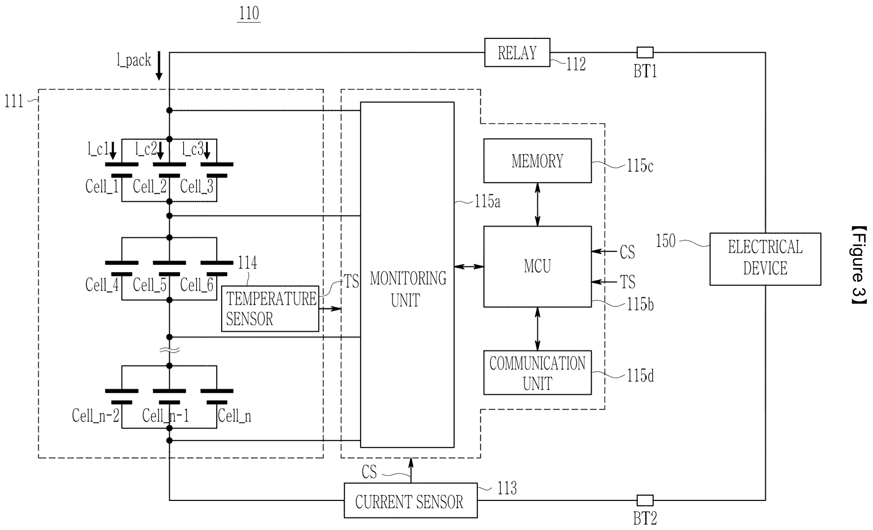

FIG. 3 is a block diagram illustrating the configuration of the battery system of FIG. 2 in detail.

Referring to FIG. 2, the vehicle 100 may include the battery system 110, a vehicle control unit 120, an on-board diagnostics (OBD) device 130, a vehicle communication unit 140, and an electrical device 150.

Referring to FIG. 3, the battery system 110 includes a battery 111, a relay 112, a current sensor 113, a temperature sensor 114, and a battery management system (BMS) 115.

Two terminals BT1 and BT2 of the battery system 110 are connected to the positive electrode and negative electrode of the battery 111, and the relay 112 is connected between the positive electrode of the battery 111 and the terminal BT1, and the current sensor 113 is connected between the negative electrode of the battery 111 and the terminal BT2. The temperature sensor 114 may be positioned at a predetermined position inside the battery system 110, for example, in an area adjacent to the battery 111, or may be positioned so as to be physically coupled to the battery 111.

The battery 111 may include a plurality of battery cells, and the plurality of battery cells may be connected in series/parallel. In FIG. 3, the battery 111 includes a plurality of battery cells Cell1-Celln, and the plurality of battery cells Cell1 to Celln consists of battery cell units connected in series, and in each battery cell unit, three battery cells are connected in parallel. However, the components shown in FIG. 3 and the connection relationship of them are an example, and the present invention is not limited thereto.

The relay 112 controls the electrical connection between the battery system 110 and the electrical device 150. When the relay 112 is turned on, the battery system 110 and the electrical device 150 are electrically connected, whereby charging or discharging is performed, and when the relay 112 is turned off, the battery system 110 and the electrical device 150 are electrically disconnected. The electrical device 150 may be a load or a charger.

Specifically, the electrical device 150 may include power conversion devices, such as inverters and converters, which convert power received from the battery 111 and supplies electricity to an on-vehicle load of the vehicle 100, such as a motor, an air conditioner, a display, etc. When the electrical device 150 is a charger, the battery 111 may be charged by energy which is supplied from the electrical device 150.

The current sensor 113 is connected in series in the current path between the battery 111 and the electrical device 150. The current sensor 113 may measure current I_pack flowing in the battery 111, and transmit a sensing signal CS indicating the measurement result to the battery management system 115. The current flowing in the battery 111 may be charging current with which the battery 111 is charged, or discharging current which is supplied from the battery 111 to the electrical device 150.

The temperature sensor 114 may sense the temperature at the location where the temperature sensor is located, and transmit a signal TS indicating the sensed temperature to the battery management system 115. The temperature sensor 114 is not limited to that shown in FIG. 3, and at least two temperature sensors may be provided to sense the temperatures of cells of a plurality of batteries.

The battery management system 115 includes a monitoring unit 115a, a main control unit (MCU) 115b, a memory 115c, and a communication unit 115d.

The monitoring unit 115a is electrically connected to the positive electrode and negative electrode of each of the plurality of battery cells Cell1-Celln, and measures the voltage of each of the plurality of battery cells Cell1-Celln.

The monitoring unit 115a transmits information on the measured cell voltage of each of the plurality of battery cells Cell1-Celln and the like to the MCU 115b. Specifically, the monitoring unit 115a may measure the cell voltage of each of the plurality of battery cells Cell1-Celln at predetermined intervals in a rest period when charging and discharging do not occur, and transmit the measured cell voltage to the MCU 115b, and the monitoring unit 115a may measure the voltage between both terminals of the battery 111 (hereinafter, referred to as the battery voltage) at predetermined intervals during constant-current charging, and transmit information on the measured battery voltage to the MCU 115b.

The MCU 115b may estimate the state of charge (SOC) of each of the plurality of battery cells, using the cell voltage of each of the plurality of battery cells Cell1-Celln received from the monitoring unit 115a during the rest period.

The MCU 115b may estimate the SOC of the battery 111. The SOC of the battery 111 may be defined as a ratio representing the charge capacity relative to the total capacity of the battery 111. For example, the SOC of the battery according to the battery voltage received from the monitoring unit 115a may be estimated 1) using an average (using the SOC of the plurality of battery cells), or 2) using a function or a table indicating the relationship between the battery voltage and the SOC of the battery. The SOC of the battery 111 may be estimated 3) by integrating the battery current. Methods of estimating the SOC of the battery according to the battery voltage may be implemented using various well-known techniques, and the present invention is not limited to a specific method.

The MCU 115b may obtain the level of the current flowing in the battery 111 during the period of charging and discharging the battery 111, on the basis of the sensing signal CS received from the current sensor 113.

The MCU 115b may determine the level of current I_c1, I_c2, or I_c3 flowing in each of the plurality of battery cells Cell1-Celln, using the received sensing signal CS. For example, the MCU 115b may calculate the current I_c1, I_c2, or I_c3 flowing in each cell by dividing the battery current level indicated by the sensing signal CS by 3.

The MCU 115b may obtain the temperature level of the battery 111 on the basis of the sensing signal TS received from the temperature sensor 114.

The memory 115c may store programs and data related to battery management operations which are performed by the MCU 115b. The memory 115c may store information obtained through the current sensor 113, the temperature sensor 114, and the monitoring unit 115a, information calculated by the MCU 115b, etc.

Specifically, the memory 115c may store battery charging information which are obtained during constant-current charging. For example, the battery charging information may include the magnitude of constant current, which is used during charging, the SOC at the start of charging, the battery temperature at the start of charging, the change in battery voltage by charging, etc.

The communication unit 115d may transmit information read from the memory 115c by the MCU 115b to the vehicle control unit 120 in response to a command of the MCU 115b, and may receive control commands which are input from the vehicle control unit 120.

The vehicle control unit 120 may generally control the vehicle 100 including the battery system 110.

Specifically, the vehicle control unit 120 may transmit a signal to adjust the battery output to the battery system 110, and may transmit the battery state, the battery charging information, and the like received from the battery system 110 to the OBD device 130, and may perform communication with the server 200 or an external terminal by controlling the vehicle communication unit 140.

The OBD device 130 may monitor the state and performance of the vehicle 100 on the basis of the information received from the vehicle control unit 120, and provide the monitored information to the driver of the vehicle 100, and may generate an error code when a problem occurs during monitoring, and provide it to the driver of the vehicle 100.

Specifically, the OBD device 130 may monitor the battery charging information received from the vehicle control unit 120 and provide the monitored battery charging information to the driver of the vehicle 100, and may generate an error code when a problem occurs during charging of the battery and provide it to the driver of the vehicle 100.

Also, the OBD device 130 may store information which is used in monitoring. For example, the OBD device 130 may store the traveling history, the battery charging information, monitoring information on the electrical device 150, etc.

The vehicle communication unit 140 may include a communication module capable of communication with the server 200. The vehicle communication unit 140 may transmit information to the server 200, and may receive information from the server 200. For example, the vehicle communication unit 140 may transmit information stored in the OBD device 130 to the server 200, and may receive estimated internal resistance from the internal resistance estimating apparatus.

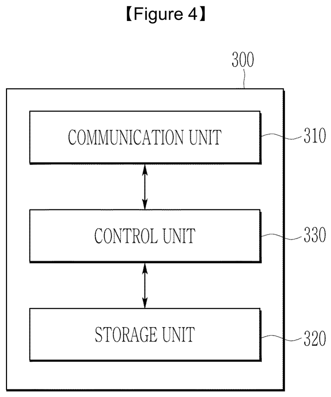

FIG. 4 is a block diagram illustrating the configuration of the battery internal resistance estimating apparatus of FIG. 1 in detail.

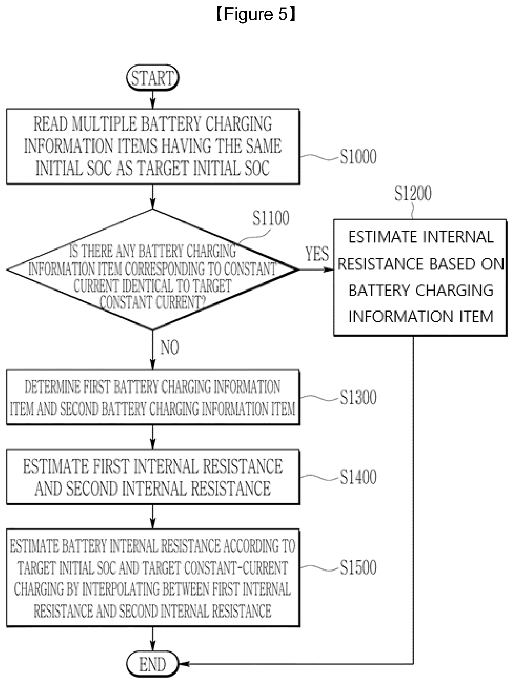

FIG. 5 is a flow chart illustrating a method of estimating battery internal resistance depending on a target initial SOC and target constant-current charging according to an exemplary embodiment.

Referring to FIG. 4, the battery internal resistance estimating apparatus 300 may include a communication unit 310, a storage unit 320, and a control unit 330.

The communication unit 310 may include a communication module capable of communicating with the server 200. Specifically, the communication unit 310 may receive vehicle information such as the battery charging information from the server 200, and may transmit estimated internal resistance to the server 200.

The storage unit 320 may store data and a program for estimating battery internal resistance. Specifically, the storage unit 320 may store a plurality of battery charging information items received from the server 200, and may store an interpolation algorithm for estimating battery internal resistance.

The control unit 330 may estimate battery internal resistance according to set battery charging conditions, on the basis of the plurality of battery charging information items stored in the storage unit 320. The battery charging conditions may include the SOC of the battery at the start of charging (hereinafter, referred to as the target initial SOC), the constant current which is used for charging (hereinafter, referred to as the target constant current Ita), and the temperature at the start of battery charging (hereinafter, referred to as the target temperature).

The battery charging conditions may be received from a user through the communication unit 310. However, setting of battery charging conditions is not limited thereto, and battery charging conditions may be set using a plurality of battery charging information items.

For example, when there are only information on charging of the battery with a constant current of 50 A and information on charging of the battery with a constant current of 70 A, battery charging conditions using, as the target constant current Ita, a constant current of 60 A which is the average of both constant currents may be set.

Referring to FIG. 5, the control unit 330 may read a plurality of battery charging information items having the same initial SOC as the target initial SOC from the storage unit 320 (S1000).

For example, when the target initial SOC is 20%, the control unit 330 may read only a plurality of battery charging information items in which the SOC at the start of charging (hereinafter, referred to as the initial SOC) is 20%, from among a plurality of battery charging information items.

The control unit 330 may determine whether there is any battery charging information item corresponding to the constant current identical to the target constant current Ita among the plurality of read battery charging information items (S1100).

For example, when the target constant current Ita is 65 A, the control unit may determine whether there is any battery charging information item representing that charging has been performed with 65 A, among the plurality of read battery charging information items.

When there is a battery charging information item corresponding to a constant current identical to the target constant current Ita among the plurality of read battery charging information items ("YES" in S1100), the control unit 330 may estimate the internal resistance based on the battery charging information item (S1200).

The control unit 330 may estimate the battery internal resistance based on the target initial SOC and the charging with the target constant current Ita by dividing the difference between the battery voltage at the start of the charging and the battery voltage at the end of the charging in the battery charging information item by the constant current which is used for charging.

Also, the control unit 330 may estimate the cell internal resistance by dividing the difference between the cell voltage at the start of the charging and the cell voltage at the end of the charging in the battery charging information item by the current flowing in each of the cells.

When there is no battery charging information item corresponding to a constant current identical to the target constant current Ita among the plurality of read battery charging information items ("NO" in S1100), the control unit 330 may determine a first battery charging information item and a second battery charging information item, using the battery charging information items (S1300).

The control unit 330 may determine two battery charging information items corresponding to two constant currents close to the target constant current Ita, as the first battery charging information item and the second battery charging information item.

Specifically, the control unit 330 may determine a battery charging information item corresponding to a first constant current I1 larger than and closest to the target constant current Ita, as the first battery charging information item, from among the read battery charging information items, and may determine a battery charging information item corresponding to a second constant current I2 smaller than and closest to the target constant current Ita, as the second battery charging information item, from among the read battery charging information items.

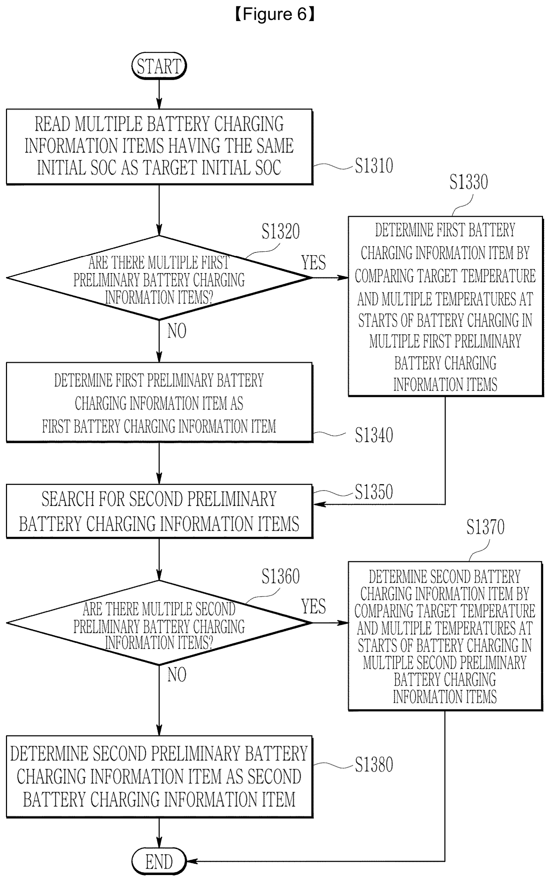

FIG. 6 is a flow chart illustrating a method of determining a first battery charging information item and a second battery charging information item according to the exemplary embodiment.

Determining the first battery charging information item and the second battery charging information item will be described with reference to FIG. 6.

The control unit 330 may search for first preliminary battery charging information items including a constant current larger than and closest to the target constant current Ita (S1310). The control unit 330 may determine where there is a plurality of first preliminary battery charging information items (S1320).

When there is a plurality of first preliminary battery charging information items (YES in S1320), the control unit 330 may determine the first battery charging information item by comparing the target temperature and a plurality of temperatures at the starts of battery charging in the plurality of first preliminary battery charging information items (S1330).

Specifically, when there is a first preliminary battery charging information item including a temperature at the start of battery charging identical to the target temperature among the plurality of first preliminary battery charging information items, the control unit 330 may determine the corresponding first preliminary battery charging information item as the first battery charging information item.

Further, when there is no first preliminary battery charging information item including a temperature at the start of battery charging identical to the target temperature among the plurality of first preliminary battery charging information items, the control unit 330 may determine a first preliminary battery charging information item having battery charging information including the temperature at the start of battery charging having the smallest difference from the target temperature, as the first battery charging information item. When the plurality of first preliminary battery charging information items includes multiple first preliminary battery charging information items including the temperature at the start of battery charging having the smallest difference from the target temperature, the control unit 330 may determine an arbitrary one of them as the first battery charging information item.

When a plurality of first preliminary battery charging information items does not exist (NO in S1320), the control unit 330 may determine the first preliminary battery charging information item as the first battery charging information item (S1340).

The control unit 330 may search for second preliminary battery charging information items including a constant current smaller than and closest to the target constant current Ita (S1350). The control unit 330 may determine whether there is a plurality of second preliminary battery charging information items (S1360).

When there is a plurality of second preliminary battery charging information items (YES in S1360), the control unit 330 may determine the second battery charging information item by comparing the target temperature and a plurality of temperatures at the starts of battery charging in the plurality of second preliminary battery charging information items (S1370).

Specifically, when there is a second preliminary battery charging information item including a temperature at the start of battery charging identical to the target temperature among the plurality of second preliminary battery charging information items, the control unit 330 may determine the corresponding second preliminary battery charging information item as the second battery charging information item.

Further, when there is no second preliminary battery charging information item including a temperature at the start of battery charging identical to the target temperature among the plurality of second preliminary battery charging information items, the control unit 330 may determine a second preliminary battery charging information item having battery charging information including the temperature at the start of battery charging having the smallest difference from the target temperature, as the second battery charging information item. When the plurality of second preliminary battery charging information items includes multiple second preliminary battery charging information items including the temperature at the start of battery charging having the smallest difference from the target temperature, the control unit 330 may determine an arbitrary one of them as the second battery charging information item.

When a plurality of second preliminary battery charging information items does not exist (NO in S1360), the control unit 330 may determine the second preliminary battery charging information item as the second battery charging information item (S1380).

Referring to FIG. 5, the control unit 330 may estimate the battery internal resistance according to the first constant current I1 (hereinafter, referred to as the first internal resistance R1), using the first battery charging information item, and may estimate the battery internal resistance according to the second constant current I2 (hereinafter, referred to as the second internal resistance R2), using the second battery charging information item (S1400).

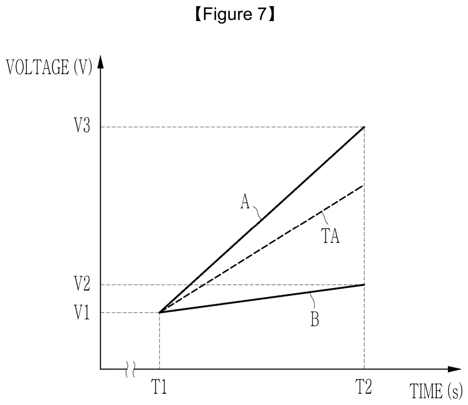

FIG. 7 is a graph illustrating the change in battery voltage over battery charging time.

A method of determining the battery internal resistance using the battery charging information will be described with reference to FIG. 7.

In the graph, the Y axis represents voltage, the X axis represents time, T1 is a charging start time, T2 is a charging end time, V1 is the battery voltage at the start of charging, V2 and V3 are the battery voltages at the end of the charging, graph A is a graph according to the first battery charging information item, and graph B is a graph according to the second battery charging information item.

The control unit 330 may determine the internal resistance by dividing the amount of voltage change during the charging period from T1 to T2 by the constant current. Specifically, the control unit 330 may determine the first internal resistance R1 by dividing the difference between the voltage V3 at the time point T2 and the voltage V1 at the time point T1 in the first battery charging information item represented by graph A by the first constant current I1, and may determine the second internal resistance R2 by dividing the difference between the voltage V2 at the time point T2 and the voltage V1 at the time point T1 in the second battery charging information item represented by graph B by the second constant current I2.

The control unit 330 may estimate the battery internal resistance according to the target initial SOC and the target constant current (Ita) charging by interpolating between the first internal resistance R1 and the second internal resistance R2 (S1500).

For example, the control unit 330 may estimate the internal resistance using Equation 1 and Equation 2. (The internal resistance according to the target constant-current charging) = R1-(R1-R2)*(I1-Ita)/(I1-I2) (The internal resistance according to the target constant-current charging) = R2+(R2-R1)*(Ita-I2)/(I1-I2)

If an interpolation between the first internal resistance R1 and the second internal resistance R2 is performed according to Equation 1 and Equation 2, the internal resistance according to the target constant-current charging having voltage characteristics as shown by graph TA in FIG. 7 may be estimated.

When the battery internal resistance according to the target constant-current charging is equal to or greater than a predetermined reference value, the control unit 330 may inform the corresponding information to the user or may transmit the corresponding information to the vehicle 100 through the server 200.

While this invention has been described in connection with what is presently considered to be practical exemplary embodiments, it is to be understood that the invention is not limited to the disclosed embodiments. On the contrary, it is intended to cover various modifications and equivalent arrangements included within the spirit and scope of the appended claims.

## Claims

1. A battery internal resistance estimating apparatus comprising:
a storage unit that stores a plurality of battery charging information items which is obtained during charging of a battery with a plurality of constant currents; and
a control unit that reads multiple battery charging information items having an initial SOC identical to a target initial SOC from among the plurality of battery charging information items, determines whether there is any battery charging information item corresponding to a constant current identical to a target constant current among the multiple read battery charging information items, and estimates the internal resistance of the battery according to the target initial SOC and the charging with the target constant current, using two battery charging information items corresponding to two constant currents close to the target constant current, when it is determined that there is no battery charging information item corresponding to a constant current identical to the target constant current.

2. The battery internal resistance estimating apparatus of claim 1, wherein:
the control unit estimates the internal resistance of the battery according to the target initial SOC and the charging with the target constant current, using a first battery charging information item corresponding to a first constant current larger than and closest to the target constant current among the multiple read battery charging information items and a second battery charging information item corresponding to a second constant current smaller than and closest to the target constant current among the multiple read battery charging information items.

3. The battery internal resistance estimating apparatus of claim 2, wherein:
the control unit determines first internal resistance of the battery, using the first battery charging information item, determines second internal resistance of the battery, using the second battery charging information item, and estimates the internal resistance of the battery according to the target initial SOC and the charging with the target constant current, on the basis of the first internal resistance and the second internal resistance.

4. The battery internal resistance estimating apparatus of claim 3, wherein:
the control unit estimates the internal resistance of the battery according to the target initial SOC and the charging with the target constant current by interpolating between the first internal resistance and the second internal resistance.

5. The battery internal resistance estimating apparatus of claim 2, wherein:
the control unit searches the multiple read battery charging information items for first preliminary battery charging information items having a constant current larger than and closest to the target constant current, and when there is a plurality of first preliminary battery charging information items, the control unit determines a preliminary battery charging information item including a temperature at the start of battery charging closest to a temperature at the start of target battery charging among the plurality of first preliminary battery charging information items, as the first battery charging information item.

6. A battery internal resistance estimating method comprising:
a step of storing a plurality of battery charging information items which is obtained during charging of a battery with a plurality of constant currents;
a step of reading multiple battery charging information items having an initial SOC identical to a target initial SOC from among the plurality of battery charging information items;
a step of determining whether there is any battery charging information item corresponding to a constant current identical to a target constant current among the multiple read battery charging information items; and
a step of estimating the internal resistance of the battery according to the target initial SOC and charging with the target constant current, using two battery charging information items corresponding to two constant currents close to the target constant current, when it is determined that there is no battery charging information item corresponding to a constant current identical to the target constant current.

7. The battery internal resistance estimating method of claim 6, wherein:
the step of estimating the internal resistance of the battery according to the target initial SOC and the charging with the target constant current includes:
a step of determining a first battery charging information item corresponding to a first constant current larger than and closest to the target constant current from among the multiple read battery charging information items;
a step of determining a second battery charging information item corresponding to a second constant current smaller than and closest to the target constant current from among the multiple read battery charging information items; and
a step of estimating the internal resistance of the battery according to the target initial SOC and charging with the target constant current, using the first battery charging information item and the second battery charging information item.

8. The battery internal resistance estimating method of claim 7, wherein:
the step of estimating the internal resistance of the battery according to the target initial SOC and charging with the target constant current, using the first battery charging information item and the second battery charging information item includes:
a step of determining first internal resistance of the battery, using the first battery charging information item;
a step of determining second internal resistance of the battery, using the second battery charging information item; and
a step of estimating the internal resistance of the battery according to the target initial SOC and the charging with the target constant current, on the basis of the first internal resistance and the second internal resistance.

9. The battery internal resistance estimating method of claim 8, wherein:
the step of estimating the internal resistance of the battery according to the target initial SOC and the charging with the target constant current, on the basis of the first internal resistance and the second internal resistance includes
a step of estimating the internal resistance of the battery according to the target initial SOC and the charging with the target constant current by interpolating between the first internal resistance and the second internal resistance.

10. The battery internal resistance estimating method of claim 7, wherein:
the step of determining the first battery charging information item corresponding to the first constant current includes:
a step of searching the multiple read battery charging information times for first preliminary battery charging information items including a constant current larger than and closest to the target constant current; and
when the number of first preliminary battery charging information items is two or more, a step of determining a first preliminary battery charging information item including a temperature at the start of battery charging closest to a temperature at the start of target battery charging, as the first battery charging information item, from among the plurality of first preliminary battery charging information items.
